Europäisches Patentamt

European Patent Office

Office européen des brevets

(11) Publication number: **0 201 325 B1**

# EUROPEAN PATENT SPECIFICATION

(45) Date of publication of patent specification: **01.04.92**  (51) Int. Cl.⁵: **H05B 3/00**, B23K 1/00

(21) Application number: **86303465.8**

(22) Date of filing: **07.05.86**

(54) **Heat source unit for processing apparatus.**

(30) Priority: **08.05.85 JP 66863/85 U**

(43) Date of publication of application:
**17.12.86 Bulletin 86/46**

(45) Publication of the grant of the patent:
**01.04.92 Bulletin 92/14**

(84) Designated Contracting States:
**FR GB IT**

(56) References cited:
**EP-A- 0 184 943     FR-A- 2 024 852**
**FR-A- 2 098 535     US-A- 3 588 425**
**US-A- 3 674 975     US-A- 4 251 305**

(73) Proprietor: **Hy-Bec Corporation**
**Yasuda Building 2-15-14 Tsukiji**
**Chuo-ku Tokyo(JP)**

(72) Inventor: **Hayakawa, Futomi c/o Japan Lamp**
**Limited**
**Yasuda Bldg 2-15-14, Tsukiji**
**Chuo-Ku Tokyo(JP)**
Inventor: **Onoda, Kazuo c/o Japan Lamp Limited**
**Yasuda Bldg 2-15-14, Tsukiji**
**Chuo-Ku Tokyo(JP)**

(74) Representative: **Ayers, Martyn Lewis Stanley**
**et al**
**J.A. KEMP & CO. 14 South Square Gray's Inn**
**London, WC1R 5EU(GB)**

## Description

The present invention relates to a non-contact type processing apparatus and, in particular, to a heat source unit having a simple construction, for example for soldering IC-chips onto printed circuit boards, end for other high temperature processing applications.

Soldering of IC-chips onto printed circuit boards can be done by using apparatus employing, for instance, laser beams or electric soldering irons. However, the use of laser beams not only requires an expensive optical system but also has the disadvantage of markedly low productivity due to the spot irradiation by the laser beam on each soldering point. The use of an electric soldering iron has the shortcoming that the connection at the processed site is often insufficient because of the flux substance, contaminants adhering on the soldering iron tip and so on. It is, therefore, necessary to remove the contaminants and to polish the soldering iron tip frequently. It is also necessary to change or replace the soldering iron tip in accordance with the alteration of type and form of the IC-chip to be soldered.

US-A-4251305 discloses a heat source lamp which comprises a mirror assembly and a radiant energy lamp. The mirror assembly is formed from two symmetrical half bodies each having a curved surface which, in use, form a concave mirror. The mirror body is provided with cooling channels through which a coolant, typically water, may be passed.

FR-A-2024852 discloses a reflector for a radiation source which has a one-part body having a concave surface on which a reflector is supported and a transparent shield plate across the front of the reflector. A groove is provided in the body behind the reflector which is connected to a source of gaseous coolant which flows along the groove and through slits in the reflector to cool the reflector and lamp.

FR-2098535 discloses a heat source lamp for soldering and desoldering in which the lamp has a mirror body formed from two symmetrical half bodies.

EP-A-0184943 discloses a soldering apparatus including heat source lamps having one-part mirror bodies provided with reflective side plates and a housing shell connected to the respective side plates.

The invention provides a heat source unit for concentrating radiant rays from a heat source lamp onto a region of a material to be heated, comprising:

a mirror assembly symmetrically composed of two half bodies each of which has an arcuate reflecting surface the two half bodies being combined together, in use, to form a concave mirror, said mirror assembly being provided with cooling canals permitting circulation through the mirror assembly of cooling fluid,

pipe connections for connecting said cooling canals to a supply and a drain of cooling fluid;

a lamp mounting for supporting a heat source lamp in front of the mirror; and means for connecting, in use, a heat source lamp, supported in use in the lamp mounting, electrically to an electric power source;

a heat resistant and light-transmissible shield plate disposed over an irradiation opening of the unit;

characterized in that

reflective side plates are mounted detachably on respective ones of opposite sides of the mirror assembly, and a housing shell is fixed detachably on said reflective side plates, and in that masking members are disposed adjustably in front of the irradiation opening of the unit, each masking member having a flat bottom plate with two upright shielding walls on opposite sides of the said bottom plate, wherein the shielding wall has a window and a fitting flange with two long holes so as to enable the masking member to be fixed adjustably to a support flange disposed at the lower end of the corresponding side plate, whereby a portion of the irradiated light is shaded by the masking members and is guided away from the main light beam through the respective windows and the most intense heat rays pass through a masking width of said shield plate defined between said masking members.

The invention is also applicable in other areas where similar heat treatment is employed. The invention will be further described by way of non-limitative example with reference to the accompanying drawings in which:

Fig. 1 shows an embodiment of the beat Source unit according to the present invention in a vertical section;

Fig. 2 is a plan view of the heat source unit of Fig. 1;

Fig. 3 is a front view of the mirror assembly employed in the heat source unit of Fig. 1;

Fig. 4 is a side view of the heat source unit of Fig. 1;

Figs. 5a to 5d illustrate in perspective view the mirror assembly, side plate housing shell components respectively;

Fig. 6 shows in perspective the masking element used in the heat source unit of Fig. 1;

Fig. 7 shows in plan view the manner of assemblage of the masking element;

Fig. 8 is an explanatory plan view of an IC-chip placed on a printed circuit board for soldering; and

Figs. 9 and 10 depict schematically the manner of formation of the radiation spot of varying length.

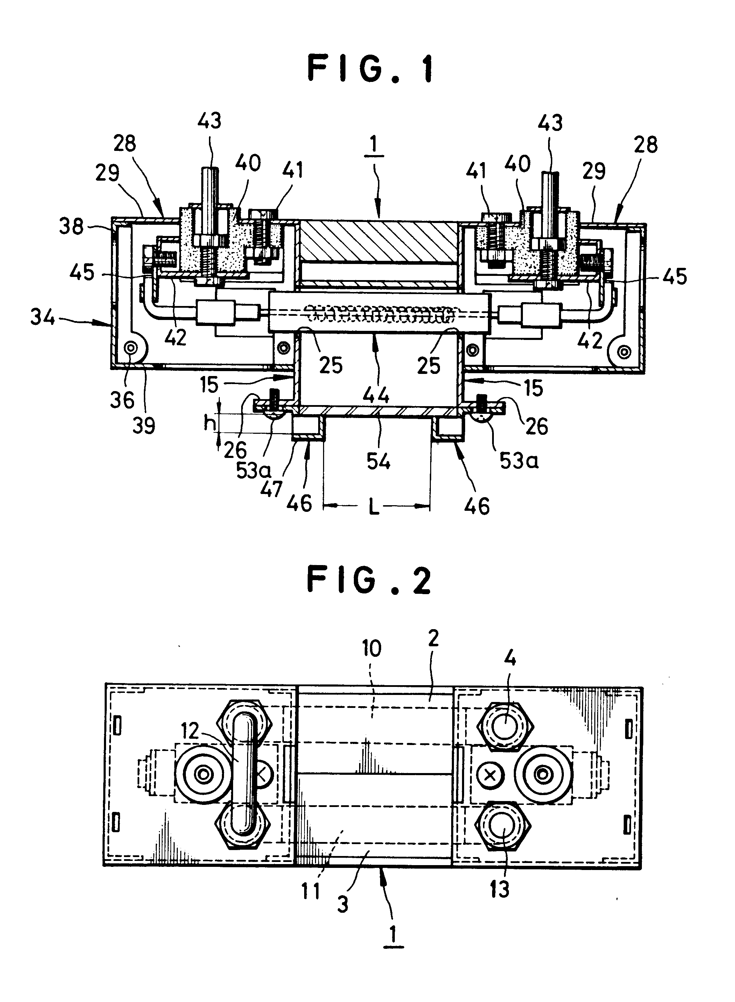

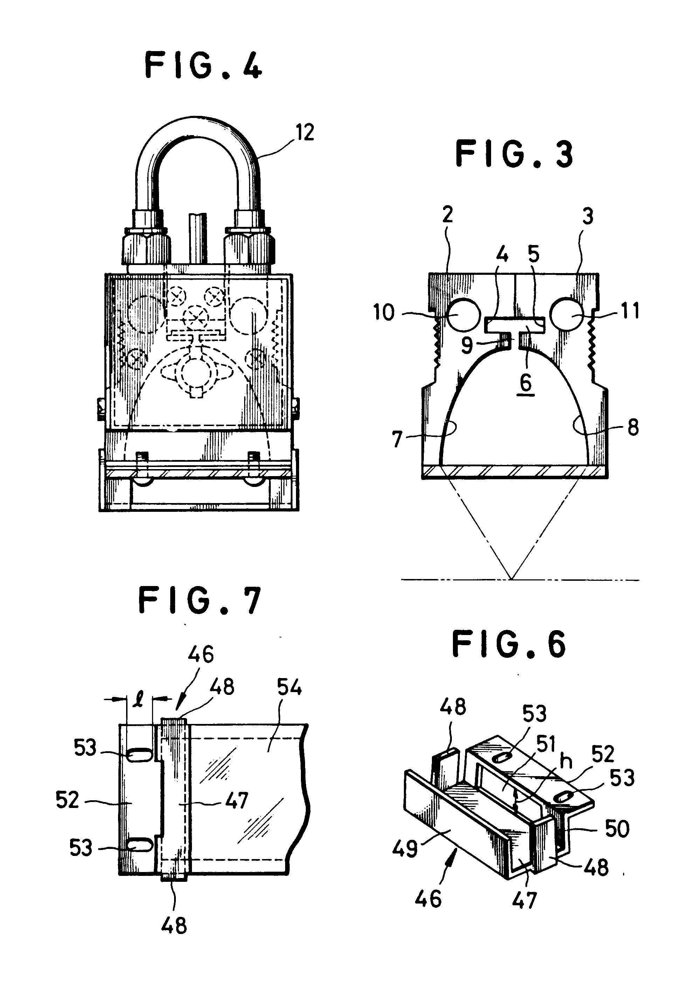

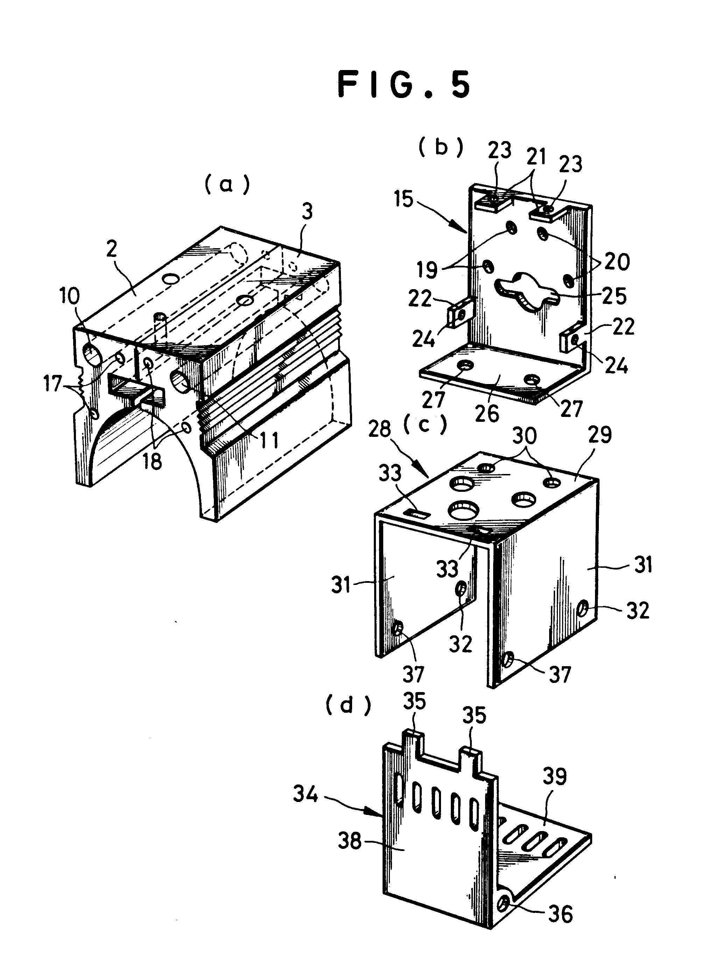

The heat source unit 1 illustrated in Figs. 1 and 2 includes a pair of symmetrical mirror half bodies 2, 3 combined together to form a mirror assembly (see Fig. 3). A rectangular cavity 6 is formed between the two mirror half bodies 2 and 3, when the two bodies are combined together, by recesses 4 and 5 in the adjoining faces thereof. The cavity 6 communicates through a connection pipe (not shown) to, for example, an air source. The two half bodies 2, 3 of the mirror assembly are each provided with a reflecting surface 7, 8 which also continues into the cavity 6 via a throat 9. Into the cavity 6 may be fed, through the connection pipe, a compressed fluid, such as, air, nitrogen or other gas. The compressed fluid so introduced passes through the throat 9 and onto the reflecting surfaces 7, 8, thereby cleaning the reflecting surfaces and preventing any contamination of the reflecting surface during the soldering operation. Alongside the cavity 6 of the mirror assembly, cooling canals 10, 11 are provided which are connected together by a connection pipe 12 and communicate to either a feed pipe 13 of an exhaust pipe 14 respectively. Cooling fluid such as water is supplied from the feed pipe 13 and flows via the cooling canal 11, connection pipe 12 and cooling canal 10 into the exhaust pipe 14.

Both sides of the mirror assembly composed of the half bodies 2, 3 are fitted with detachable reflective side plates 15 of the same configuration. Each of the reflective side plates 15 is fitted onto the corresponding side face of the mirror assembly in such a manner, that fitting holes 17, 18 disposed on the side face of the mirror assembly are aligned with fitting holes 19, 20 disposed on the reflective side plate 15. The side plates 15 are attached detachably using fitting screws. The reflective side plate 15 is provided on its upper and both side edges with fitting lugs 21, 22 (see Fig. 5b). The fitting lugs 21, 22 have each a fitting hole 23, 24. Near the center of each reflective side plate, there is provided a lamp insertion hole 25 in the form of a circular hole having diametrically opposed cutouts. The reflective side plate 15 has at its lower end a support flange 26 formed by a right angle fold and provided with a pair of fixing holes 27.

On the fitting lugs 21 of both the side plates is supported a chassis 28 having folded down side walls 31 and an upper bridging plate 29 which rests on the fitting lugs. The upper bridging plate 29 is provided with fitting holes 30 which are aligned with the fitting holes 23, 23 in the lugs 21 and the chassis is attached detachably to the side plate 15 using fitting screws inserted in the aligned fitting holes. Fitting holes 32, 32 formed on each of the side walls 31, 31 of the chassis are aligned with the fitting holes 24, 24 of the fitting lugs 22 and the two are detachably connected together by fitting screws. Each upper bridging plate 29 is provided with slits 33, 33 and each chassis 28 is fitted with a closure plate 34 shaped, so as to form with the chassis a respective housing shell. The closure plate 34 is attached to the chassis 28 by inserting two projections 35, 35 disposed on the upper edge of the closure plate into said plate into said slits 33, 33 of the upper bridging plate 29, while aligning fitting holes 36 provided at the corner portion of the closure plate 34 with fitting holes 37, 37 formed in the chassis 28 and then fixing by fitting screws. The web portion 38 (vertical side) of the closure plate 34 closes the side opening of the chassis 28 and the flange portion 39 (horizontal side) thereof closes the bottom of the chassis 28.

An insulator 40, 40 is disposed on each of the upper bridging plates 29 of the chassis 28 by fixing screw 41 (see Fig. 1). An electric terminal member 42 disposed on the insulator 40 is connected detachably to a lead line 43, and also to a junction terminal 45 connecting to the heat source lamp 44. The heat source lamp 44 is supported by the insertion holes 25 formed in both reflective side plates 15, 15.

On each support flange 26, disposed at the lower end of each of the reflective side plates 15, a masking element 46 is fixed detachably by tightening fixing screws inserted in the fixing holes 27. The masking element 46 has a flat bottom plate 47 and upright ends 48, at both ends of the bottom plate 47 as shown in Figs. 6 and 7. On both sides of the bottom plate 47, there are formed integrally therewith two upright shielding walls 49, 50 opposite each other. The shielding wall 50 has a fitting flange 52 formed bodily therewith and a window 51. The fitting flange 52 has two long holes 53 so as to enable the masking element to be fixed to the support flange 26 whilst allowing adjustment of the distance between the pair of masking elements, by tightening adjusting screws 53a, 53a inserted in the long holes and screwed into the support flange. The irradiation opening of the heat source unit is shielded by a transparent shield plate 54 which is supported by the pair of masking elements 46. The shield plate 54 is made of a heat resistant and light-transmissible material, such as, quartz glass, Pyrex (trade name) and so on. The masking width "L" may be chosen by selecting the length $\ell$ by adjusting the distance between the masking elements. The portion of irradiated light scattered, and thus having low radiation intensity is shaded by the masking elements 46 and is guided away for the main light beam by selecting an adequate height "h" of the window 51, whereby the most intense heat rays pass through the masking width "L" and, a sharp beam of heat rays can be obtained.

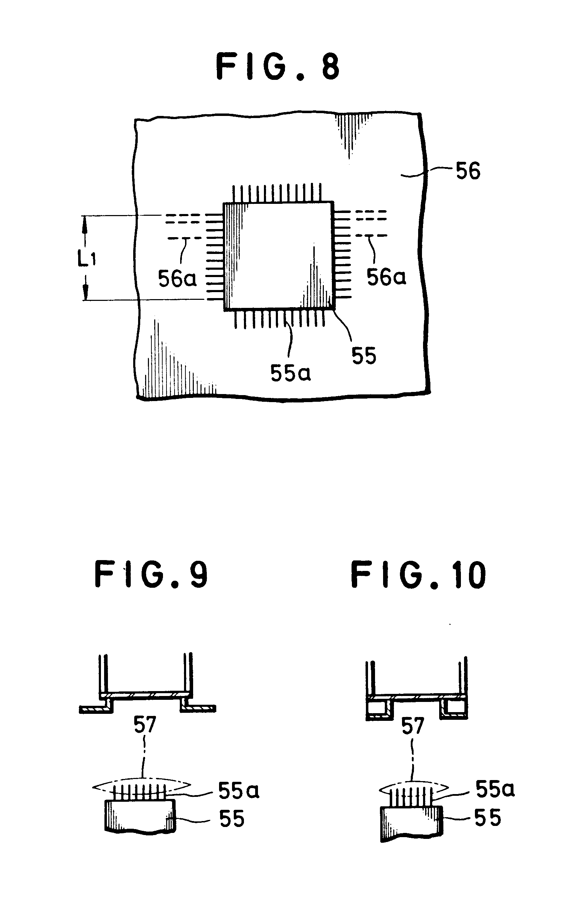

Turning now to Fig. 8, this shows a soldering procedure for a flat square IC-chip 55 placed on a printed circuit board 56 (cf. Fig. 8). The IC-chip 55 has a row of terminals 55a on each side edge. With respect to each row of terminals of the IC-chip, there is arranged a corresponding row of lead line terminals 56a on the printed circuit board. Each corresponding pair of terminals 55a and 56a is connected by soldering using the irradiation heat rays from the heat source unit according to the present invention. Care must be taken here especially so that the radiation of the heat rays is restricted to the processing range, namely the range defined by the width "L" in Fig. 8, and should not be directed to other areas. For this purpose, the masking width "L" of the heat source unit corresponding to the processing range "$L_1$" is selected by adjusting the width between the masking elements 46, i.e. the adjusting screws 53a are unfastened and the masking elements 46 are shifted relatively to each other. When soldering a linear spot having a length "$L_1$" of, for example, 24 mm, the masking width "L" is adjusted so as to obtain a heat ray bundle with a profile length of 24 mm by shifting the masking elements 46, 46 relative to each other, as shown in Fig. 9. If the length of the soldering spot "$L_1$" amounts to, for example, 20 mm, the masking elements 46, 46 are shifted in the same manner so as to obtain a heat ray beam 57 having a profile length of 20 mm, as shown in Fig. 10. After the masking width has been adjusted in accordance with the length of the soldering spot as explained above, cooling water is fed from the feed pipe 13. The cooling water circulates through the cooling canal 11 and the connection pipe 12 into the cooling canal 10 and exits through the exhaust pipe 14. The material to be processed 55, 56 is positioned at a predetermined processing position. By switching on the electric power source, the heat source lamp 44 is lit up and irradiates heat rays within a predetermined range as explained above and the soldering sites are soldered.

The heat source unit according to the present invention permits an efficient irradiation of processing sites of various forms with a high energy heat ray beam with a correspondingly selected masking width, so that there are no adverse effects on areas other than the site to be processed, and so that a reliable soldered connection may be obtained. Moreover, the unit is compact, is easy to handle and is convenient to maintain and inspect.

Furthermore replacement of parts is made easy by the ease of disassembly of the unit.

## Claims

1. A heat source unit for concentrating radiant rays from a heat source lamp onto a region of a material to be heated, comprising:

   a mirror assembly symmetrically composed of two half bodies (2,3), each of which has an arcuate reflecting surface (7,8) the two half bodies (2,3) being combined together, in use, to form a concave mirror, said mirror assembly being provided with cooling canals (10,11) permitting circulation through the mirror assembly of cooling fluid,

   pipe connections (13,14) for connecting said cooling canals (10,11) to a supply and a drain of cooling fluid;

   a lamp mounting (25) for supporting a heat source lamp in front of the mirror; and means for connecting, in use, a heat source lamp, supported in use in the lamp mounting (25), electrically to an electric power source;

   a heat resistant and light-transmissible shield plate (54) disposed over an irradiation opening of the unit;

   characterized in that

   reflective side plates (15) are mounted detachably on respective ones of opposite sides of the mirror assembly, and a housing shell (28 and 29) is fixed detachably on said reflective side plates (15), and in that masking members (46) are disposed adjustably in front of the irradiation opening of the unit, each masking member (46) having a flat bottom plate with two upright shielding walls (49, 50) on opposite sides of the said bottom plate, wherein the shielding wall (50) has a window (51) and a fitting flange (52) with two long holes (53) so as to enable the masking member to be fixed adjustably to a support flange (26) disposed at the lower end of the corresponding side plate, whereby a portion of the irradiated light is shaded by the masking members (46) and is guided away from the main light beam through the respective windows (51) and the most intense heat rays pass through a masking width ("L") of said shield plate (54) defined between said masking members (46).

2. A heat source unit according to claim 1 further provided with a heat source lamp (44) mounted in said lamp mounting (25).

3. A heat source unit according to claim 1 or 2 characterised in that the cooling fluid supplied, in use, to the mirror assembly is water.

4. A heat source unit according to claim 1, 2 or 3 characterised in that the mirror assembly is adapted to allow cleaning fluid to be directed onto the reflective surface (7, 8) of the mirror assembly without disassembling the unit.

5. A heat source unit according to any one of the preceding claims characterized in that the mounting (25) for the heat source lamp (44) is formed by the reflective side plates (15).

## Revendications

1. Unité de source de chaleur pour concentrer des rayons rayonnant d'une lampe source de chaleur sur une région d'un matériau à chauffer, comprenant :
   - un ensemble de miroir composé symétriquement de deux demi-corps (2,3), dont chacun a une surface réfléchissante courbe (7,8), les deux demi-corps (2,3) étant combinés ensemble, en utilisation, pour former un miroir concave, cet ensemble de miroir comportant des canaux de refroidissement (10,11) permettant à un fluide de refroidissement de circuler à travers l'ensemble de miroir;
   - des tubes de raccordement (13,14) pour raccorder ces canaux de refroidissement (10,11) à une source et à une évacuation de fluide de refroidissement;
   - un montage de lampe (25) pour supporter une lampe source de chaleur devant le miroir; et des moyens pour raccorder électriquement à une source de courant électrique, en utilisation, une lampe source de chaleur supportée en utilisation dans le montage de lampe (25);
   - une plaque de protection résistant à la chaleur et transparente à la lumière (54) disposée sur une ouverture d'exposition de l'unité;
   caractérisée en ce que des plaques latérales réfléchissantes (15) sont montées de façon amovible sur des côtés opposés respectifs de l'ensemble de miroir, qu'un boîtier (28,29) est fixé de façon amovible sur ces plaques latérales réfléchissantes (15) et en ce que des éléments de masquage (46) sont disposés de façon réglable devant l'ouverture d'exposition de l'unité, chaque élément de masquage (46) ayant un fond plat avec deux parois de protection verticales (49,50) sur des côtés opposés de ce fond, la paroi de protection (50) ayant une fenêtre (51) et un rebord de montage (52) avec deux trous allongés (53) de façon à pouvoir fixer de façon réglable l'élément de masquage sur un rebord support (26) disposé au niveau de l'extrémité inférieure de la plaque latérale correspondante, d'où il résulte qu'une portion de la lumière rayonnée est occultée par l'élément de masquage (46) et est guidée loin du faisceau lumineux principal à travers les fenêtres respectives (51) et que les rayons calorifiques les plus intenses passent à travers une largeur de masquage ("L") de cette plaque de protection (54) définie entre les éléments de masquage (46).

2. Unité de source de chaleur selon la revendication 1, comportant en outre une lampe source de chaleur (44) montée dans le montage de lampe (25).

3. Unité de source de chaleur selon la revendication 1 ou la revendication 2, caractérisée en ce que le fluide de refroidissement alimentant, en service, l'ensemble de miroir, est de l'eau.

4. Unité de source de chaleur selon l'une des revendications 1 à 3, caractérisée en ce que l'ensemble de miroir est adapté pour laisser diriger un fluide de nettoyage sur la surface réfléchissante (7,8) de l'ensemble de miroir sans démontage de l'unité.

5. Unité de source de chaleur selon l'une quelconque des revendications précédentes, caractérisée en ce que le montage (25) pour la lampe source de chaleur (44) est formé par les plaques latérales réfléchissantes (15).

## Patentansprüche

1. Heizeinheit, die von einer Heizlampe ausgehende Strahlung auf einen Bereich eines zu heizenden Materials konzentriert, umfassend
   eine Spiegelanordnung, die symmetrisch aus zwei Halbkörpern (2,3) zusammengesetzt ist, von denen jede eine gewölbte reflektierende Oberfläche (7,8) aufweist, wobei die beiden Halbkörper (2,3) während des Gebrauchs so zusammengebracht werden, daß sie einen konkaven Spiegel bilden und die Spiegelanordnung mit Kühlkanälen (10,11) versehen ist, die die Zirkulation eines Kühlfluids durch die Spiegelanordnung erlauben,
   Rohrverbindungen (13,14) zum Verbinden der Kühlkanäle (10,11) mit einem Zu- und einem Abfluß für Kühlfluid,
   eine Lampenfassung (25) zum Halten einer Heizlampe vor dem Spiegel, und Vorrichtungen zum elektrischen Anschließen einer Heizlampe während des Betriebs, die während des Betriebs in der Lampenfassung (25) gehalten wird, an eine elektrische Energiequelle,
   eine über einer Lichtöffnung der Einheit angebrachte hitzebeständige und lichtdurchlässige Schutzscheibe (54),
   dadurch gekennzeichnet, daß

reflektierende Seitenplatten (15) abnehmbar an entsprechenden der gegenüberliegenden Seiten der Spiegelanordnung montiert sind, und ein Gehäuse (28,29) abnehmbar an diesen reflektierenden Seitenplatten (15) befestigt ist, und daß Maskenbauteile (46) einstellbar vor der Lichtöffnung der Einheit angebracht sind, wobei jedes Maskenbauteil (46) eine flache untere Platte mit zwei aufrechten Abschirmwänden (49,50) an gegenüberliegenden Seiten der unteren Platte hat, wovon die Abschirmwand (50) ein Fenster (51) und einen Befestigungsflansch (52) mit zwei Langlöchern (53) aufweist, so daß das Maskenbauteil einstellbar an einem am unteren Ende der entsprechenden Seitenplatte befindlichen Halteflansch (26) befestigt werden kann, wodurch ein Teil des ausgestrahlten Lichts durch das Maskenbauteilen (46) abgeschirmt und durch die entsprechenden Fenster (51) vom Hauptlichtstrahl weggeführt wird, und die intensivste Wärmestrahlung durch eine zwischen den Maskenbauteilen (46) definierte Maskenbreite ("L") der Schutzscheibe (54) tritt.

2. Heizeinheit nach Anspruch 1, gekennzeichnet durch eine Heizlampe (44) die in der Lampenfassung (25) montiert ist.

3. Heizeinheit nach Anspruch 1 oder 2, dadurch gekennzeichnet, daß das im Gebrauch der Spiegeleinheit zugeführte Kühlfluid Wasser ist.

4. Heizeinheit nach Anspruch 1,2 oder 3, dadurch gekennzeichnet, daß die Spiegeleinheit so ausgebildet ist, daß Reinigungsflüssigkeit auf die reflektierenden Oberflächen (7,8) des Spiegels geleitet werden kann, ohne die Einheit zu zerlegen.

5. Heizeinheit nach einem der vorhergehenden Ansprüche, dadurch gekennzeichnet, daß die Fassung (25) für die Heizlampe (44) durch die reflektierenden Seitenplatten (15) gebildet wird.

EP 0 201 325 B1

# F I G . 1

# F I G . 2

7

FIG.4

FIG.3

FIG.7

FIG.6

# FIG. 5

(a)

(b)

(c)

(d)

# FIG. 8

56

L1

56a    56a

55

55a

# FIG.9

57

55a
55

# FIG.10

57

55a
55